(19) Europäisches Patentamt
European Patent Office
Office européen des brevets

(11) **EP 3 400 636 B1**

(12) **EUROPÄISCHE PATENTSCHRIFT**

(45) Veröffentlichungstag und Bekanntmachung des Hinweises auf die Patenterteilung:
**09.03.2022   Patentblatt 2022/10**

(21) Anmeldenummer: **17717069.3**

(22) Anmeldetag: **04.01.2017**

(51) Internationale Patentklassifikation (IPC):
*H01S 5/068* (2006.01)       *H01S 5/042* (2006.01)
*H05B 45/32* (2020.01)       *H05B 45/345* (2020.01)
*G05F 1/10* (2006.01)

(52) Gemeinsame Patentklassifikation (CPC):
**H01S 5/06808; G05F 1/10; H01S 5/0427;**
H05B 45/32; H05B 45/345

(86) Internationale Anmeldenummer:
**PCT/DE2017/100003**

(87) Internationale Veröffentlichungsnummer:
**WO 2017/118455 (13.07.2017 Gazette 2017/28)**

(54) **SCHALTUNGSANORDNUNG UND VERFAHREN ZUM STEUERN UND MESSEN EINES STROMS IN EINEM LASTELEMENT**

CIRCUIT AND METHOD FOR CONTROLLING AND MEASURING A CURRENT IN A CHARGE ELEMENT

CIRCUIT ET PROCÉDÉ DE COMMANDE ET DE MESURE D'UN COURANT DANS UN ÉLÉMENT DE CHARGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.01.2016   EP 16150111**

(43) Veröffentlichungstag der Anmeldung:
**14.11.2018   Patentblatt 2018/46**

(73) Patentinhaber: **Silicon Line GmbH**
**80687 München (DE)**

(72) Erfinder: **BELLINGRATH, Thomas**
**15537 Gruenheide (Mark) (DE)**

(74) Vertreter: **Hofmann, Andreas et al**
**RGTH**
**Patentanwälte PartGmbB**
**Postfach 33 02 11**
**80062 München (DE)**

(56) Entgegenhaltungen:
**DE-A1- 10 240 914          DE-A1- 10 258 766**
**DE-A1- 10 344 486          DE-A1-102005 046 980**
**DE-B3-102008 032 556      US-A1- 2002 158 654**

EP 3 400 636 B1

## Beschreibung

### Technisches Gebiet

Die vorliegende Erfindung betrifft eine Schaltungsanordnung sowie ein Verfahren zum Steuern und Messen eines elektrischen Laststroms in mindestens einem Lastelement, insbesondere in mindestens einer Laserdiode (vgl. die DE 10 2008 032 556 B3 bezüglich des Oberbegriffs des Anspruchs 1).

### Stand der Technik, insbesondere dessen Nachteile und technische Probleme

Aktiv-optische Kabel oder aktive optische Kabel (AOCs = active optical cables) bestehen aus Sende- und Empfangselementen, die in die Stecker eingebaut sind und ein Datensignal auf der Strecke dazwischen optisch über einen Lichtwellenleiter übertragen. In diesem Kontext werden low-power Lasertreiber für niedrige Betriebsspannungen benötigt. Ein Lasertreiber für ein Datensignal muss einerseits den verwendeten Laserstrom modulieren, sowie andererseits den dabei erzeugten mittleren Modulationsstrom kontrollieren. Die Schwierigkeit besteht dabei darin, einerseits höchste Schaltgeschwindigkeiten zu erreichen und andererseits einen vorgegebenen Arbeitspunkt des Lasers einzustellen.

Oft werden Laserstrom und Schaltzustand eines Lasers mit separaten Schaltelementen eingestellt, so dass zwei Schaltelemente (Transistoren) mit entsprechendem Spannungsabfall dafür in Serie benötigt werden. Der zusammen mit dem Laser mindestens benötigte Spannungsabfall limitiert jedoch die Anwendbarkeit innerhalb vorgegebener Betriebsspannungsgrenzen.

Treiben von Laserdioden in CMOS-Technologien für direkte Modulation mit Datensignalen wird oft in Source-Folger-Konfiguration durchgeführt, um beim niederohmigen Treiben der Kapazität der Laserdiode die sogenannte Class AB-Charakteristik, das heißt die dynamische Stromveränderung, dieser Konfiguration auszunützen.

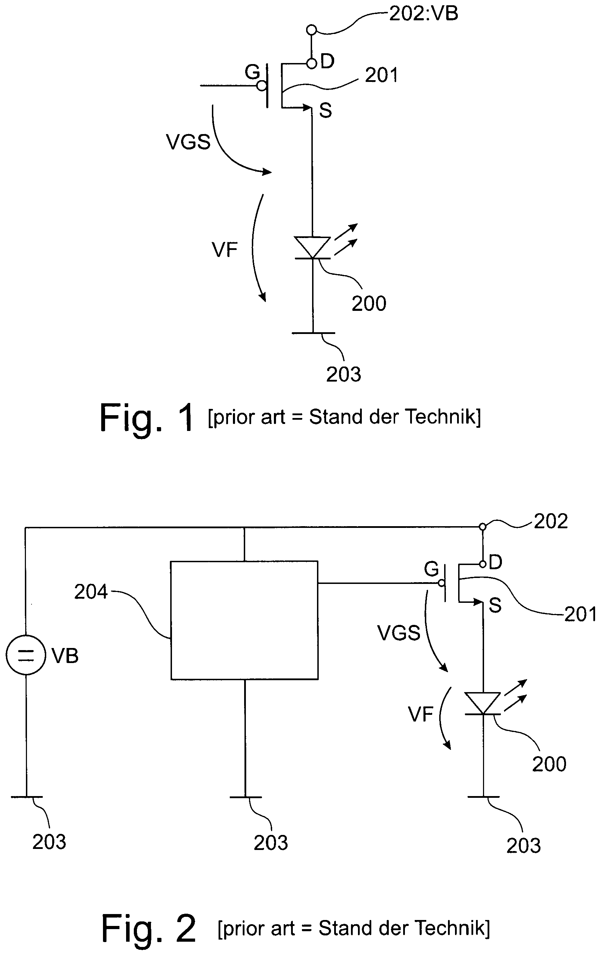

Fig. 1 zeigt dazu ein Prinzipschaltbild einer einfachen Treiberschaltung für eine hier als Lastelement eingesetzte Laserdiode 200 mit einem Feldeffekttransistor 201 in Sourcefolger-Schaltung. Dabei ist D ein Drainanschluss des Feldeffekttransistors 201, G ein Gateanschluss des Feldeffekttransistors 201 und S ein Sourceanschluss des Feldeffekttransistors 201.

Ein Hauptstrompfad, das heißt die Drain-Source-Strecke, des Feldeffekttransistors 201 ist mit der Laserdiode 200 zwischen einem Betriebsspannungsanschluss 202, an dem eine Betriebsspannung VB abgegeben wird, und Masse 203 in Reihenschaltung angeordnet.

Zwischen dem Gateanschluss G und dem Sourceanschluss S liegt eine Gate-Source-Spannung VGS an, die sich aus einer Arbeitspunkt-Gleichspannung Vt, auch als Schwellenspannung bezeichnet, und einer Modulations-Wechselspannung ΔV, auch als Spannung zur Aussteuerung des Feldeffekttransistors bezeichnet, als deren Summe zusammensetzt:

$$VGS = Vt + \Delta V$$

Über der Laserdiode 200 als Last liegt eine Vorwärtsspannung VF an.

Der dabei in Summe nötige Spannungsabfall Vsum über der Laserdiode 200 und dem treibenden Transistor, das heißt dem Feldeffekttransistor 201, insbesondere einem MOSFET, muss also mindestens enthalten:

- die Vorwärtsspannung VF der Laserdiode 200;
- die Schwellenspannung Vt des treibenden MOSFETs 201;
- die Spannung ΔV zur Aussteuerung des MOSFETs 201:

$$Vsum \geq VGS + VF = Vt + \Delta V + VF$$

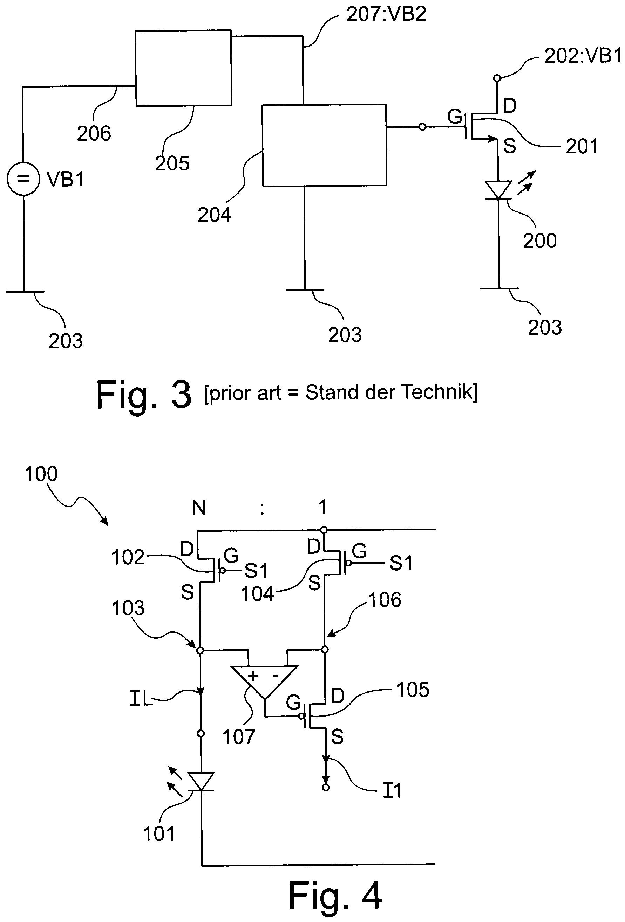

Um diese Konfiguration in Low-Power Anwendungen, das heißt Anwendungen für niedrige Betriebsspannungen, verwenden zu können, muss also entweder eine für den Treiber verfügbare Betriebsspannung VB mindestens entsprechend hoch sein, wie dies in der Schaltungsanordnung gemäß Fig. 2 schematisch dargestellt ist, oder schaltungsintern eine höhere zweite Betriebsspannung VB2 als eine externe erste Betriebsspannung VB1 erzeugt werden, wie in Fig. 3 schematisch wiedergegeben.

In der Schaltungsanordnung gemäß Fig. 2 sind sowohl die Reihenschaltung aus der Laserdiode 200 und dem Hauptstrompfad, das heißt der Drain-Source-Strecke, des Feldeffekttransistors 201 als auch ein Lasertreiber, also eine Ansteuerungsschaltung 204 für den Feldeffekttransistor 201, zwischen dem Betriebsspannungsanschluss 202 und Masse 203 angeordnet. Die zur Ansteuerung benötigte Betriebsspannung VB ist entsprechend hoch zu wählen, was zu einem hohen Leistungsverbrauch der Schaltungsanordnung führt.

In der Schaltungsanordnung gemäß Fig. 3, die ein Beispiel zur internen Erzeugung einer höheren Betriebsspannung zeigt, ist die Ansteuerungsschaltung 204 für den Feldeffekttransistor 201 über einen Gleichspannungswandler 205 an die erste Betriebsspannung VB1 angeschlossen, die im Übrigen auch dem Betriebsspannungsanschluss 202 zugeleitet wird und derart bemessen ist, dass damit die Reihenschaltung aus Feldeffekttransistor 201 und Laserdiode 200 betrieben werden kann.

Die demgegenüber höhere zweite Betriebsspannung VB2 zum Speisen der Ansteuerschaltung 204 wird einem Ausgang 207 des Gleichspannungswandlers 205 entnommen, dem die erste Betriebsspannung VB1 an einem Eingang 206 zugeführt wird. Für diese Konfiguration ist ein hoher Schaltungsaufwand erforderlich; außerdem ist beim Einsatz des Gleichspannungswandlers 205 eine genaue Analyse auftretender Zeitkonstanten nötig, um Störungen zu vermeiden.

Der Laserstrom, das heißt der Strom durch die Laserdiode 200, wird dabei oft entweder nur gesteuert oder an einem Serienwiderstand gemessen, der einen zusätzlichen Spannungsabfall verursacht.

Lasertreiber in einer sogenannten Common-Source-Konfiguration gelten wegen der Miller-Kapazität des Transistors als schlecht geeignet für hohe Datenraten bzw. schnelle Signale.

**Darstellung der vorliegenden Erfindung: Aufgabe, Lösung, Vorteile**

Ausgehend von den vorstehend dargelegten Nachteilen und Unzulänglichkeiten sowie unter Würdigung des umrissenen Stands der Technik liegt der vorliegenden Erfindung die Aufgabe zugrunde, eine Schaltungsanordnung sowie ein Verfahren zum Steuern und Messen eines Stroms in mindestens einem Lastelement, insbesondere in mindestens einer Laserdiode, zur Verfügung zu stellen, die bei niedriger Betriebsspannung mit Laserstromregelung und/oder mit geringem Spannungsabfall einsetzbar ist, also für sogenannte "Low-Power"-Anwendungen geeignet ist.

Erfindungsgemäß wird diese Aufgabe durch eine Schaltungsanordnung mit den Merkmalen des Anspruchs 1 sowie durch ein Verfahren mit den Merkmalen des Anspruchs 10 gelöst. Anspruch 13 definiert eine erfindungsgemäße Verwendung der Schaltungsanordnung bzw. des Verfahrens. Vorteilhafte Ausgestaltungen und zweckmäßige Weiterbildungen der vorliegenden Erfindung sind in den jeweiligen Unteransprüchen gekennzeichnet.

Die vorliegende Erfindung stellt mit anderen Worten eine Schaltungsanordnung sowie ein Verfahren zum Steuern und Messen eines Stroms in mindestens einem Lastelement, insbesondere eines Laserstroms, zur Verfügung, aufweisend ein Lastschaltelement, das in Serie mit dem Lastelement, zum Beispiel einer Laserdiode, liegt, und einen gepaarten Pfad durch das Messpfadschaltelement, über dem mit Hilfe des Hilfsreglers und des ersten Spannungsstellelements die Spannung in Abhängigkeit von der Spannung über dem Lastschaltelement kontrolliert wird, so dass ein zum Laserstrom proportionaler Messstrom erzeugt wird.

Die erfindungsgemäße Schaltungsanordnung bildet eine Treiberschaltung, insbesondere einen leistungseffizienten Lasertreiber für niedrige Betriebsspannungen mit einer Laserstromregelung und/oder mit geringem Spannungsabfall, und ermöglicht es, Arbeitspunkt und Schaltzustand mit einem einzigen in Serie liegenden Element zu kontrollieren. Dies ist für Anwendungen mit geringer Betriebsspannung, sogenannte "Low-power"-Anwendungen, vorteilhaft.

Zur Begriffsklärung sei noch ergänzt, dass eine Paarung - englischsprachig auch als "Matching" bezeichnet - von Halbleiterschaltungselementen darin besteht, mehrere Bauteile, zum Beispiel durch geeignete Halbleitertopographie, das heißt Layoutmaßnahmen, so anzulegen, dass sie identische bzw. sehr ähnliche Eigenschaften aufweisen.

Es ist auch möglich, solchermaßen angeglichene Eigenschaften bis auf einen Skalierungsfaktor zu erzielen; insbesondere betrifft die Paarung hier das Verhältnis der von den betreffenden Halbleiterschaltungselementen durchflossenen Ströme, das gleich eins oder von eins verschieden ausgelegt sein kann.

Dies Letztere wird im Folgenden mit "anteilig paaren" bzw. mit "anteilige Paarung" beschrieben. Für weitere Erläuterungen hierzu wird verwiesen auf die Monographie "Halbleiter-Schaltungstechnik" von U. Tietze und Ch. Schenk, erschienen im Springer-Verlag, 8. Auflage, 1986, insbesondere Seite 64 und Seite 69.

Erfindungsgemäß wird, sofern gemäß einer bevorzugten Ausführungsform das mindestens eine Lastelement als mindestens eine Laserdiode ausgebildet ist, ein variabler Modulationsanteil des Laserstromes durch ein einziges mit dem Laser in Serie liegendes Schaltelement mit definiertem Mittelwert erzeugt und mit einem gepaarten Pfad oder mehreren gepaarten Pfaden bestimmt, um die Ansteuerung des Schaltelementes auf einen Pegel zu regeln, der den gewünschten Mittelwert des Modulationsstromes einstellt.

Gemäß der vorliegenden Erfindung sind die erfindungsgemäße Schaltungsanordnung und das erfindungsgemäße Verfahren jeweils gekennzeichnet durch einen zweiten Messpfad mit einem mit dem Lastschaltelement in vorgebbarem Paarungsverhältnis gepaarten zweiten Messpfadschaltelement und einem mit dem zweiten Messpfadschaltelement in Serie angeordneten zweiten Spannungsstellelement, wobei das zweite Messpfadschaltelement zum Steuern durch ein zum ersten Steuersignal komplementäres zweites Steuersignal und das zweite Spannungsstellelement zum mit dem ersten Spannungsstellelement gemeinsamen Steuern durch den Hilfsregler eingerichtet ist, so dass ein zweiter Messstrom im zweiten Messpfadschaltelement und im zweiten Spannungsstellelement erzeugt wird, dessen Variation zu derjenigen des Laststroms umgekehrt proportional ist.

Die derart weitergebildete Schaltungsanordnung enthält einen weiteren gepaarten Pfad, der komplementär angesteuert wird und einen Strom mit komplementärem Wechsel- bzw. Signalanteil erzeugt.

Bei einer weiteren bevorzugten Ausführungsform sind das Lastschaltelement, das erste Messpfadschaltelement und/oder das zweite Messpfadschaltelement an Ausgangsanschlüssen einseitig mit je einem kapazitiven Bauelement verbunden, das anderseitig zum Zuführen eines zum dem betreffenden Schaltelement zugeführten Steuersignal komplementären Signals eingerichtet ist.

Bei dieser Ausführungsform werden die Eingangskapazitäten der Schalter, das heißt des Lastschaltelements, des ersten und/oder des zweiten Messpfadschaltelements, durch Kapazitäten zu einem komplementären Signal hin vorkompensiert.

In einer vorteilhaften Weiterbildung sind/ist die erfindungsgemäße Schaltungsanordnung und/oder das erfindungsgemäße Verfahren gekennzeichnet durch einen Schaltungsblock zum Bilden des ersten und wahlweise zusätzlich des zweiten Steuersignals zum Steuern des Lastschaltelements, des ersten und/oder des zweiten Messpfadschaltelements, wobei der Schaltungsblock zum Zuführen einer Amplitudenstellspannung und zum Bilden des ersten und wahlweise zusätzlich des zweiten Steuersignals mit einer von der Amplitudenstellspannung und/oder einer dem Schaltungsblock zuführbaren Betriebsspannung abhängigen Amplitude eingerichtet ist.

In dieser Weiterbildung wird die erfindungsgemäße Schaltungsanordnung mit einem Schaltungsblock kombiniert, der die erfindungsgemäße Schaltungsanordnung ansteuert und ein Ausgangssignal sowie vorzugsweise auch ein zu diesem Ausgangssignal komplementäres Signal variabler Amplitude liefert, wobei die variable Amplitude von einer Steuerspannung, hier als Amplitudenstellspannung bezeichnet, oder einer Betriebsspannung der Schaltungsanordnung abhängt.

Nach einer bevorzugten Weiterbildung der vorliegenden Erfindung ist diese dadurch gekennzeichnet, dass

- der Schaltungsblock mit CMOS-Bauelementen ausgebildet ist,
- die Amplitudenstellspannung zumindest nahezu gleich einer zum Betreiben der CMOS-Bauelemente vorgesehenen Betriebsspannung ist, und
- der Schaltungsblock dazu eingerichtet ist, die Amplitudenstellspannung als Betriebsspannung zugeführt zu erhalten und das erste und wahlweise zusätzlich das zweite Steuersignal mit einer zur Betriebsspannung proportionalen Ausgangsamplitude zu bilden.

Bei dieser Weiterbildung der vorliegenden Erfindung entspricht also die Steuerspannung, das heißt die Amplitudenstellspannung, der Betriebsspannung eines CMOS-Blocks, der damit eine zur Betriebsspannung proportionale Ausgangsamplitude des ersten und wahlweise zusätzlich des zum ersten Steuersignal komplementären zweiten Steuersignals liefert.

Bei einer weiteren bevorzugten Ausführungsform ist der Schaltungsblock mit einer Einrichtung zum Zuführen eines unsymmetrischen Modulationssignals und zum daraus Bilden des ersten Steuersignals und wahlweise zusätzlich des zweiten Steuersignals als zumindest nahezu symmetrische oder Gegentaktsignale ausgebildet.

Insbesondere ist diese Einrichtung mit zwei parallelen Zweigen ausgebildet, denen das unsymmetrische Modulationssignal parallel zuführbar ist und die je eine Multiplikationsstufe umfassen, die dazu ausgebildet sind, dass darin das unsymmetrische Modulationssignal mit gegensinnig gepolten Steuerspannungen, das heißt insbesondere der Amplitudenstellspannung in positiver bzw. negativer Polung, multipliziert wird.

Die Multiplikationsstufen sind ausgangsseitig vorzugsweise mit je einer Inverter-Ausgangsstufe aus zwei mit ihren Hauptstrompfaden zwischen der Betriebsspannung und Masse in Reihenschaltung angeordneten Transistoren, vorzugsweise Feldeffekttransistoren, gekoppelt.

Eine vorteilhafte Weiterbildung ist gekennzeichnet durch eine Regeleinrichtung, die eingerichtet ist zum

- Zuführen des ersten und wahlweise des zweiten Messstroms,
- Auswerten des ersten und wahlweise des zweiten Messstroms und
- auf dieser Grundlage Bilden und Einstellen der dem Schaltungsblock zuführbaren Amplitudenstellspannung und/oder Betriebsspannung derart, dass ein Zielwert des ersten Messstroms oder wahlweise einer Linearkombination des ersten und zweiten Messstroms und damit ein Zielwert des Modulationsstroms, das heißt des durch das erste Steuersignal modulierten Laststroms, erreicht wird.

Diese Regeleinrichtung, kurz auch als Regler bezeichnet, wertet einen oder mehrere der zum Laststrom proportionalen Messströme, das heißt den ersten und wahlweise zusätzlich den zweiten Messstrom, aus einer Schaltungsanordnung der vorbeschriebenen Art aus und stellt darauf basierend die Steuerspannung, das heißt Amplitudenstellspannung, oder Betriebsspannung an einem Schaltungsblock der vorbeschriebenen Art ein, so dass ein Zielwert, das heißt Sollwert, des ersten Messstroms bzw. ein Zielwert einer Linearkombination, zum Beispiel der Summe, der Messströme und damit des entsprechenden Modulationsstroms erreicht wird.

Gemäß einer bevorzugten Weiterbildung ist die Regeleinrichtung zum Bilden eines Summensignals aus der Summe des ersten und zweiten Messstroms eingerichtet, wobei das Summensignal eine gegenüber dem ersten und dem zweiten Messstrom geringere und/oder langsamere zeitliche Variation aufweist.

Gemäß dieser Weiterbildung der Regeleinrichtung werden die gegenläufig variierenden Messströme addiert, so dass das resultierende Summensignal zeitlich wesentlich langsamer variiert und einfacher zur Regelung verwendet werden kann. In diese Addition können die Messströme mit unterschiedlichen Gewichtungsfaktoren eingehen, so dass außer einer einfachen Addition auch eine gewichtete Linearkombination der Messströme möglich ist.

Besonders bevorzugt ist eine Kombination einer der vorbeschriebenen Ausbildungen der Schaltungsanordnung und/oder des Verfahrens zum Steuern und Messen eines elektrischen Laststroms in mindestens einem Lastelement mit einem Schaltungsblock, auch als Ansteuerblock bezeichnet, der vorbeschriebenen Art und einem Regler der vorbeschriebenen Art.

Nach einer anderen Ausführungsform ist zum Lastschaltelement und/oder zum ersten Messpfadschaltelement und/oder zum zweiten Messpfadschaltelement je eine mit dem betreffenden der Schaltelemente in vorgebbarem Paarungsverhältnis gepaarte Konstantstromquelle in Parallelschaltung angeordnet, wobei insbesondere die Konstantstromquellen in einem gleichen oder ähnlichen Paarungsverhältnis zueinander dimensioniert sind wie das Lastschaltelement, das erste Messpfadschaltelement und/oder das zweite Messpfadschaltelement untereinander.

Bei dieser Ausführungsform sind also zusätzliche, in ähnlichem Verhältnis wie das Lastschaltelement und das erste Messpfadschaltelement und wahlweise zusätzlich das zweite Messpfadschaltelement gepaarte Konstantstromquellen am Lastschaltelement und am ersten Messpfadschaltelement und wahlweise zusätzlich am zweiten Messpfadschaltelement angebracht, also am Lastpfad und den gepaarten Messpfaden, angebracht, um je einen Minimalstrom im Lastelement und in dem Messpfad bzw. den Messpfaden vorzugeben.

In einer vorteilhaften Weiterbildung ist das Lastelement mit einer Laserdiode ausgebildet. Dies stellt eine bevorzugte Anwendung der Erfindung dar. Die erfindungsgemäße Schaltungsanordnung ermöglicht eine Steuerung und/oder Messung des Laststroms, das heißt hier des Stroms in der Laserdiode, auch als Laserstrom bezeichnet, bei geringen Betriebsspannungen und somit einen leistungsarmen Betrieb.

Die vorliegende Erfindung und ihre bevorzugten Ausgestaltungen zeichnen sich durch die nachfolgenden besonderen Merkmale und Vorteile aus:

- Das Lastelement, insbesondere eine Laserdiode, wird mit dem Drainanschluss eines Feldeffekttransistors bei niedriger Drain-Source-Spannung angesteuert.

- In einem Schaltungsblock, vorzugsweise einem mit CMOS-Bauelementen ausgebildete Schaltungsblock, kurz auch als CMOS-Schaltungsblock bezeichnet, wird ein erstes und wahlweise zusätzlich ein zweites Steuersignal zum Steuern des Lastschaltelements, des ersten und wahlweise zusätzlich des zweiten Messpfadschaltelements gebildet; insbesondere sind das erste und das zweite Steuersignal komplementär zueinander. Die Betriebsspannung des Schaltungsblocks ist zwecks Amplitudenregelung der Steuersignale stell- bzw. regelbar.

- Am Sourceanschluss des Lastschaltelements bzw. des Messpfadschaltelements oder der Messpfadschaltelemente wird das zu dem am Gateanschluss des betreffenden Schaltelements zugeführten Steuersignal inverse bzw. komplementäre Steuersignal kapazitiv eingekoppelt. Dadurch wird eine Kompensation der Knotenkapazität am Drainanschluss des jeweiligen Schaltelements, das heißt Feldeffekttransistors inklusive einer Kompensation des Miller-Effekts der Ansteuerung des Gateanschlusses durch das betreffende Steuersignal, einer Kompensation der Laserdioden-Kapazität, usw. erzielt, um dennoch hohe Modulationsraten zu erreichen.

- Die Schaltelemente, das heißt Feldeffekttransistoren, werden auf einen definierten Durchlasswiderstand, auch als "R_on" bezeichnet, durch genau zur gewünschten Strom-Modulationstiefe passende Spannungspegel am Gateanschluss eingestellt.

- Zum auch als Laserstrompfad bezeichneten Lastpfad mit dem Lastschaltelement und dem Lastelement, das heißt der Laserdiode, sind ein oder zwei gepaarte Pfade zum Messen des Stroms im Lastelement, insbesondere des Laserstroms, eingerichtet. In diesen gepaarten Pfaden werden die mit Steuertransistoren gebildeten Messpfadschaltelemente auf gleichem Arbeitspunkt wie das Lastschaltelement, insbesondere als Treiber-FET für den Laserstrom ausgestaltet, gehalten.

- Die zum Einstellen der definierten Durchlasswiderstände der Feldeffekttransistoren erforderlichen Spannungspegel werden durch eine Strommessung an dem mindestens einen zum Lastpfad mit dem Lastschaltelement und dem Lastelement, das heißt der Laserdiode, gepaarten Pfad und durch eine Regelung der Betriebsspannung für den CMOS-Schaltungsblock sichergestellt.

- Die vorgenannte Strommessung wird vorzugsweise zum Regeln von Ausgangspegeln einer Vorstufenschaltung, auch als "Pre-Driver-Schaltung" bezeichnet, verwendet, zum Beispiel durch Regelung der Betriebsspannung des vorgenannten Schaltungsblocks, vorzugsweise des mit CMOS-Bauelementen ausgebildeten Schaltungsblocks, kurz CMOS-Schaltungsblocks.

- Die Paarung des Lastpfades bzw. Lastschaltelements mit dem bzw. den Messpfaden bzw. Messpfadschaltelementen kann in unterschiedlich wählbaren Paarungsverhältnissen erfolgen. Dies trifft insbesondere dann zu, wenn zwei Messpfade ausgebildet sind und die darin gemessenen einzelnen Messströme zu einem resultierenden Messstrom kombiniert werden. Im einfachsten Fall kann dabei eine Paarung zwischen dem Laststrom und den Messströmen in einem Verhältnis von N:1:1 gewählt und können die Messströme durch einfache Addition, vorzugsweise in einem Stromknoten, kombiniert werden. Statt dessen kann die Paarung zwischen dem Laststrom und den Messströmen in einem davon beliebig abweichenden Verhältnis von zum Beispiel N:a:b mit a ≠ b vorgenommen sein. Dann sind beliebige Linearkombinationen der einzelnen Messströme, bei denen diese unterschiedlich gewichtet sein können, möglich. Auch ist eine Paarung der Messströme untereinander im Verhältnis 1:1 mit einer anschließenden Gewichtung der einzelnen Messströme durch unterschiedliche Gewichtungsfaktoren in einer Überlagerungsstufe möglich.

- Die erfindungsgemäße Schaltungsanordnung kommt mit niedrigem Spannungsabfall über dem Lastelement, insbesondere der Laserdiode, und dem zugehörigen Lastschaltelement, vorzugsweise Treibertransistor, insbesondere Feldeffekttransistor, aus; eine Erzeugung von höheren Betriebsspannungen ist nicht notwendig.

- Die Strommessung am gepaarten Messpfad benötigt keinen Spannungsabfall im Lastpfad.

- Durch Bereitstellen zweier mit zueinander komplementären Steuersignalen angesteuerter, gepaarter Messpfade zur Strommessung wird ein Einfluss des aktuellen zeitlichen Verlaufs des Modulationssignals auf die Arbeitspunktregelung des Lastelements, insbesondere der Laserdiode, verhindert und damit eine vom Modulationssignal unabhängige Bandbreite in einer Regelstrecke zum Regeln des Stroms im Lastelement, auch als Laststrom oder hier vorzugsweise Laserstrom bezeichnet, erzielt. Die Modulationsabhängigkeit der Messströme wird bei deren Addition bzw. Kombination verringert bzw. kompensiert.

Die vorliegende Erfindung betrifft schließlich die Verwendung mindestens einer Schaltungsanordnung gemäß der vorstehend dargelegten Art und/oder eines Verfahrens gemäß der vorstehend dargelegten Art zum Treiben mindestens eines Lastelements, insbesondere mindestens einer Laserdiode, in der optischen Datenübertragung, insbesondere in mindestens einem aktiv-optischen Kabel (AOC).

So können in einem Umsetzungsbeispiel der vorliegenden Erfindung drei MOSFETs für einen Lastpfad und zwei Messpfade anteilig gepaart und über einen Hilfsregler am selben Arbeitspunkt gehalten werden, so dass sie den Modulationsstrom und in festem Verhältnis dazu stehende Vergleichsströme liefern.

Die Vergleichsströme können zur Bestimmung des mittleren Modulationsstroms genutzt werden und eine Regeleinrichtung speisen, die diese - und damit auch den mittleren Modulationsstrom - auf einen Sollwert bringt, indem eine Betriebs- oder Steuerspannung an einem Schaltungsblock durch die Regeleinrichtung variiert wird. Der Schaltungsblock liefert dabei in der Amplitude von der Betriebs- oder Steuerspannung abhängige Ausgangssignale, die zwei oder mehr Schaltelemente im Lastpfad und den Messpfaden ansteuern.

**Kurze Beschreibung der Zeichnungen**

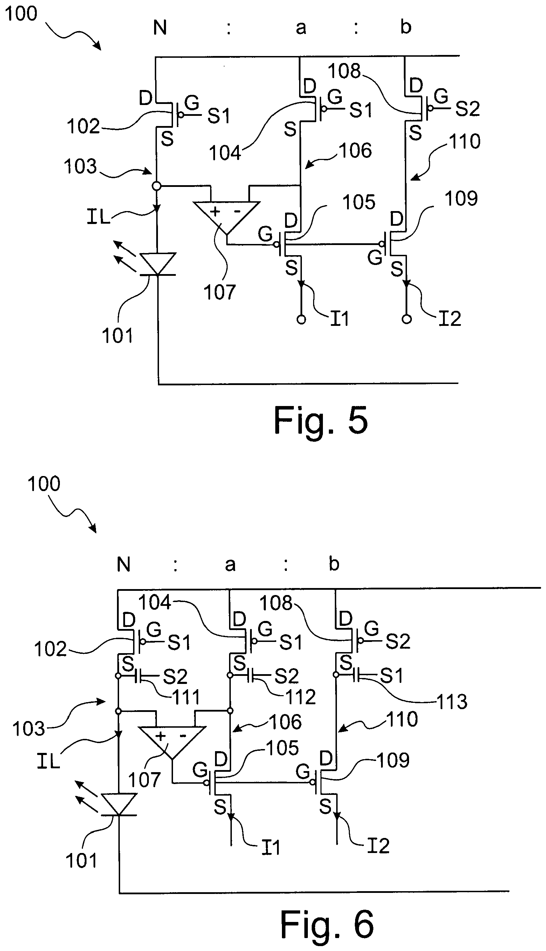

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 sowie die dem Anspruch 10 nachgeordneten Ansprüche verwiesen, andererseits werden weitere Ausgestaltungen, Merkmale und Vorteile der vorliegenden Erfindung nachstehend unter anderem anhand der durch Fig. 5 bis Fig. 13 veranschaulichten Ausführungsbeispiele näher erläutert.

Es zeigt:

Fig. 1 ein Prinzipschaltbild einer einfachen Treiberschaltung für eine hier als Lastelement eingesetzte Laserdiode mit einem Feldeffekttransistor in Sourcefolger-Schaltung;

Fig. 2 ein Prinzipschaltbild einer Schaltungsanordnung, bei der sowohl die Reihenschaltung aus der Laserdiode und dem Hauptstrompfad des Feldeffekttransistors als auch eine Ansteuerungsschaltung für den Feldeffekttransistor zwischen einer gemeinsamen Betriebsspannung und Masse angeordnet sind;

Fig. 3 eine Abwandlung des Prinzipschaltbilds der Schaltungsanordnung gemäß Fig. 1, bei der die Reihenschaltung aus der Laserdiode und dem Hauptstrompfad des Feldeffekttransistors an eine erste Betriebsspannung angeschlossen ist und bei der die Ansteuerungsschaltung für den Feldeffekttransistor zur internen Erzeugung einer höheren Betriebsspannung über einen Gleichspannungswandler an die erste Betriebsspannung angeschlossen ist;

Fig. 4 ein zum Stand der Technik gehörendes Beispiel für eine Schaltungsanordnung mit einem Lastpfad, hier Laserstrompfad, mit dem Lastschaltelement und dem Lastelement, das heißt der Laserdiode, und einem dazu gepaarten ersten Messpfad;

Fig. 5 eine Abwandlung des Beispiels aus Fig. 4, wobei diese Abwandlung eine gemäß dem erfindungsgemäßen Verfahren arbeitende erfindungsgemäße Schaltungsanordnung mit einem Lastpfad und einem dazu gepaarten ersten Messpfad sowie einem dazu gepaarten zweiten Messpfad zeigt;

Fig. 6 eine Abwandlung des Ausführungsbeispiels für eine gemäß dem erfindungsgemäßen Verfahren arbeitende erfindungsgemäße Schaltungsanordnung gemäß Fig. 5, bei der das Lastschaltelement und die Messpfadschaltelemente an Ausgangsanschlüssen einseitig
mit je einem kapazitiven Bauelement verbunden sind, das anderseitig zum Zuführen eines
zum dem betreffenden Schaltelement zugeführten Steuersignal komplementären Signals eingerichtet ist;

Fig. 7   eine Abwandlung des Ausführungsbeispiels
für eine gemäß dem erfindungsgemäßen Verfahren arbeitende erfindungsgemäße Schaltungsanordnung gemäß Fig. 6 mit einem
Schaltungsblock zum Bilden von Steuersignalen zum Steuern des Lastschaltelements und
der Messpfadschaltelemente;

Fig. 8   eine Abwandlung des Ausführungsbeispiels
für eine gemäß dem erfindungsgemäßen Verfahren arbeitende erfindungsgemäße Schaltungsanordnung gemäß Fig. 7, bei der weitere
Einzelheiten des Schaltungsblocks grob
schematisch dargestellt sind;

Fig. 9   eine grob schematische Darstellung einer Regeleinrichtung, die mit dem Schaltungsblock
gemäß Fig. 7 oder gemäß Fig. 8 zum Zuführen
einer Amplitudenstellspannung und/oder Betriebsspannung zusammenwirkt;

Fig. 10  eine Abwandlung der gemäß dem erfindungsgemäßen Verfahren arbeitenden Anordnung
gemäß Fig. 9 mit einer grob schematischen
Darstellung der Bildung eines resultierenden
Messstroms aus einer Linearkombination der
einzelnen Messströme in den Messpfaden;

Fig. 11  eine grob schematische Darstellung einer
vollständigen, gemäß dem erfindungsgemäßen Verfahren arbeitenden Schaltungsanordnung gemäß den Ausführungsbeispielen gemäß Fig. 7 oder Fig. 8 mit einer Regeleinrichtung gemäß den Ausführungsbeispielen gemäß Fig. 9 oder Fig. 10;

Fig. 12  eine grob schematische Darstellung einer
vollständigen, gemäß dem erfindungsgemäßen Verfahren arbeitenden erfindungsgemäßen Schaltungsanordnung, dem Ausführungsbeispiel gemäß Fig. 11 folgend, in einer
Ausführungsform mit PMOS-Feldeffekttransistoren; und

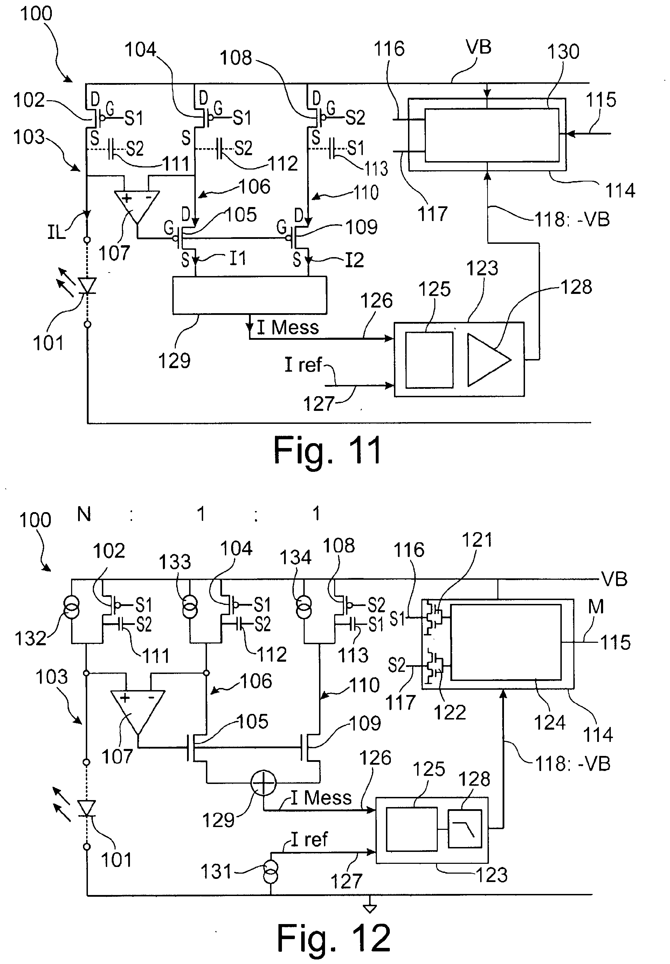

Fig. 13  eine grob schematische Darstellung einer
vollständigen, gemäß dem erfindungsgemäßen Verfahren arbeitenden erfindungsgemäßen Schaltungsanordnung, dem Ausführungsbeispiel gemäß Fig. 11 folgend, in einer
Abwandlung der Ausführungsform gemäß
Fig. 12 mit NMOS-Feldeffekttransistoren.

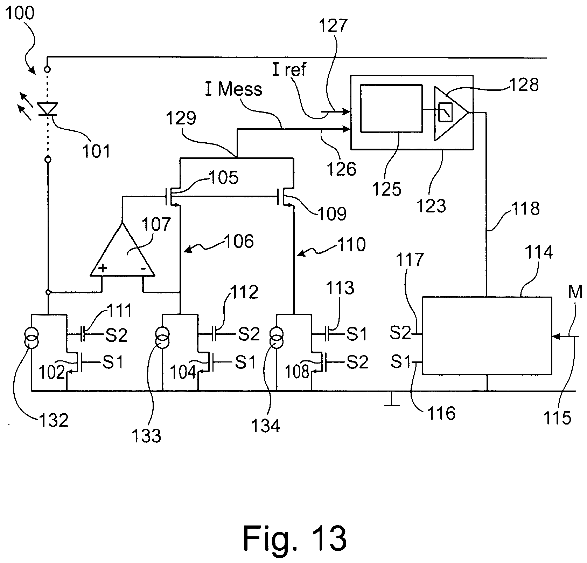

Gleiche, ähnliche oder übereinstimmende Ausgestaltungen, Elemente oder Merkmale sind in Fig. 1 bis
Fig. 13 mit denselben Bezugszeichen versehen; es wird
auf eine wiederholte Beschreibung dieser Ausgestaltungen, Elemente oder Merkmale verzichtet.

**Bevorzugte Ausführungsform der Erfindung; bester
Weg zur Ausführung der vorliegenden Erfindung**

Zur Vermeidung überflüssiger Wiederholungen
beziehen sich die nachfolgenden Erläuterungen sowohl
auf das Beispiel aus Fig. 4 als auch hinsichtlich der Ausgestaltungen, Merkmale und Vorteile der vorliegenden
Erfindung - soweit nicht anderweitig angegeben - auf alle
anhand Fig. 5 bis Fig. 13 veranschaulichten Ausführungsbeispiele der vorliegenden Erfindung.

In Fig. 4 ist mit dem Bezugszeichen 100 ein
Beispiel einer Schaltungsanordnung aus dem Stand der
Technik bezeichnet: Die Schaltungsanordnung 100 umfasst einen Lastpfad 103, hier Laserstrompfad, der mit
einem Lastelement 101, hier einer Laserdiode, und einem Lastschaltelement 102, hier einem Feldeffekttransistor, insbesondere einem MOSFET, ausgebildet ist,
wobei die Laserdiode 101 und eine einen Hauptstrompfad bildende Drain-Source-Strecke zwischen einem
Drainanschluss D und einem Sourceanschluss S des
MOSFET 102 in Reihenschaltung angeordnet sind.

Die Schaltungsanordnung 100 umfasst weiterhin einen zum Lastpfad 103 gepaarten ersten Messpfad
106, der mit einem ersten Messpfadschaltelement 104,
hier ebenfalls einem Feldeffekttransistor, insbesondere
einem MOSFET, und einem mit dem ersten Messpfadschaltelement 104 in Serie, das heißt Reihenschaltung,
angeordneten ersten Spannungsstellelement 105, das
ebenfalls mit einem Feldeffekttransistor, insbesondere
mit einem MOSFET, ausgebildet ist.

Insbesondere sind dabei das Lastschaltelement 102 und das erste Messpfadschaltelement 104 gepaart, und zwar hier vorzugsweise anteilig gepaart im
Verhältnis N:1. Das bedeutet, dass ein Laststrom IL im
Lastschaltelement 102 und damit auch im Lastelement
101 das N-fache eines ersten Messstroms I1 im ersten
Messpfadschaltelement 104 und damit auch im ersten
Spannungsstellelement 105 beträgt, sofern das Lastschaltelement 102 und das erste Messpfadschaltelement 104 übereinstimmend angesteuert werden:

$$IL = N * I1$$

Diese übereinstimmende Ansteuerung ist hier
durch ein erstes Steuersignal S1 gegeben, das sowohl
einem Gateanschluss G des Lastschaltelements 102 als
auch einem Gateanschluss G des ersten Messpfadschaltelements 104 zugeleitet wird.

Außerdem ist zum Einstellen dieser übereinstimmenden Ansteuerung des Lastschaltelements 102
und des ersten Messpfadschaltelements 104 ein Hilfsregler 107 vorgesehen, der hier vorzugsweise als Operationsverstärker ausgestaltet ist.

Je einer der Eingangsanschlüsse des Hilfsreglers 107 ist mit dem Sourceanschluss S des Lastschaltelements 102 bzw. des ersten Messpfadschaltelements
104 verbunden. Ein Ausgangsanschluss des Hilfsreglers 107 ist mit einem Gateanschluss G ersten Spannungsstellelements 105 verbunden.

Auf diese Weise ist der Hilfsregler 107 zum Steuern des ersten Spannungsstellelements 105 in Abhängigkeit von einer Differenz der Spannungen über dem Lastschaltelement 102 und über dem ersten Messpfadschaltelement 104 derart eingerichtet, dass die Spannung über dem Messpfadschaltelement 104 in Abhängigkeit von der Spannung über dem Lastschaltelement 102 kontrolliert wird.

Fig. 5 zeigt in Form einer Abwandlung des Beispiels aus Fig. 4 ein Ausführungsbeispiel für eine erfindungsgemäße Schaltungsanordnung 100. Diese Abwandlung umfasst zusätzlich zum Lastpfad 103 und dem dazu gepaarten ersten Messpfad 106 noch einen dazu gepaarten zweiten Messpfad 110, wobei das Paarungsverhältnis des Lastpfads 103, des ersten Messpfads 106 und des zweiten Messpfads 110 nun verallgemeinert N:a:b beträgt, das heißt der Laststrom IL, der erste Messstrom I1 und ein zweiter Messstrom I2 im zweiten Messpfad 110 verhalten sich gemäß der Beziehung IL:I1:I2 = N:a:b.

Der zweite Messpfad 110 ist mit einem zweiten Messpfadschaltelement 108, hier ebenfalls einem Feldeffekttransistor, insbesondere einem MOSFET, und einem mit dem zweiten Messpfadschaltelement 108 in Serie, das heißt Reihenschaltung, angeordneten zweiten Spannungsstellelement 109, das ebenfalls mit einem Feldeffekttransistor, insbesondere mit einem MOSFET, ausgebildet ist, ausgestaltet. Insbesondere sind dabei das Lastschaltelement 102, das erste Messpfadschaltelement 104 und das zweite Messpfadschaltelement 108 gepaart, und zwar hier vorzugsweise anteilig gepaart im Verhältnis N:a:b.

Das erste und das zweite Spannungsstellelement 105, 109 werden über ihre Gateanschlüsse G gemeinsam vom Ausgangsanschluss des Hilfsreglers 107 angesteuert, mit dem sie verbunden sind. Dadurch wird die Spannung am Lastschaltelement 102 auf die Spannungen an den beiden Messpfadschaltelementen 104, 108 übertragen.

Im Gegensatz zu dem ersten Messpfadschaltelement 104 wird dem zweiten Messpfadschaltelement 108 an seinem Gateanschluss G ein zweites Steuersignal S2 zugeführt. Durch das zweite Steuersignal S2 wird der zweite Messpfad 110 komplementär zum ersten Messpfad 106 und zum Lastpfad 103 ausgesteuert.

Wie nachfolgend noch näher erläutert ist, werden die Steuersignale aus einem Modulationssignal gewonnen, das eine Folge binärer Daten umfasst, die über die Laserdiode übertragen werden sollen. Dieses Modulationssignal, das heißt die Datenfolge, geht außer in den Laserstrom IL auch in die Messströme I1, I2 ein und übt einen störenden Einfluss auf die Strommessung und damit die Arbeitspunktregelung der Laserdiode 101 aus.

In zwei aus komplementär angesteuerten Messpfaden 106, 110 gewonnenen Messströmen I1, I2 treten die Modulationssignalanteile aus den Steuersignalen S1, S2 gegenläufig auf und lassen sich durch Linearkombination, vorzugsweise Addition, der Messströme I1, I2 zumindest weitgehend aufheben, so dass die Arbeitspunktregelung der Laserdiode 101 vom Modulationssignal und damit auch vom Modulationsstrom, das heißt von dem durch die Modulation des Laserstroms IL hervorgerufenen Wechselstromanteil im Laststrom IL, zumindest weitgehend unabhängig ist.

Fig. 6 zeigt eine Abwandlung der Schaltungsanordnung 100 gemäß Fig. 5. Dabei sind zusätzlich zu Fig. 5 das Lastschaltelement 102 und die Messpfadschaltelemente 104, 108 an Ausgangsanschlüssen, hier den Sourceanschlüssen S der Feldeffekttransistoren, einseitig mit je einem kapazitiven Bauelement 111, 112 bzw. 113 verbunden.

Anderseitig wird dem betreffenden kapazitiven Bauelement 111, 112 bzw. 113 dasjenige der beiden Steuersignale S1, S2 zugeführt, das zu dem Steuersignal S1 bzw. S2 komplementär ist, das dem betreffenden Schaltelement zugeführt wird.

Im Einzelnen bedeutet dies, dass

- dem Lastschaltelement 102 an seinem Gateanschluss G das erste Steuersignal S1 und an seinem Sourceanschluss S über ein erstes 111 der kapazitiven Bauelemente 111, 112 bzw. 113 das zum ersten Steuersignal S1 komplementäre zweite Steuersignal S2 zugeleitet wird,
- dem ersten Messschaltelement 104 an seinem Gateanschluss G das erste Steuersignal S1 und an seinem Sourceanschluss S über ein zweites 112 der kapazitiven Bauelemente 111, 112 bzw. 113 das zum ersten Steuersignal S1 komplementäre zweite Steuersignal S2 zugeleitet wird und
- dem zweiten Messschaltelement 108 an seinem Gateanschluss G das zweite Steuersignal S2 und an seinem Sourceanschluss S über ein drittes 113 der kapazitiven Bauelemente 111, 112 bzw. 113 das zum zweiten Steuersignal S2 komplementäre erste Steuersignal S1 zugeleitet wird.

Durch die Verbindung der kapazitiven Bauelemente 111, 112 bzw. 113 werden die Eingangskapazitäten des Lastschaltelements 102, des ersten und/oder des zweiten Messpfadschaltelements 104 bzw. 108 zu dem jeweils komplementären Signal hin vorkompensiert.

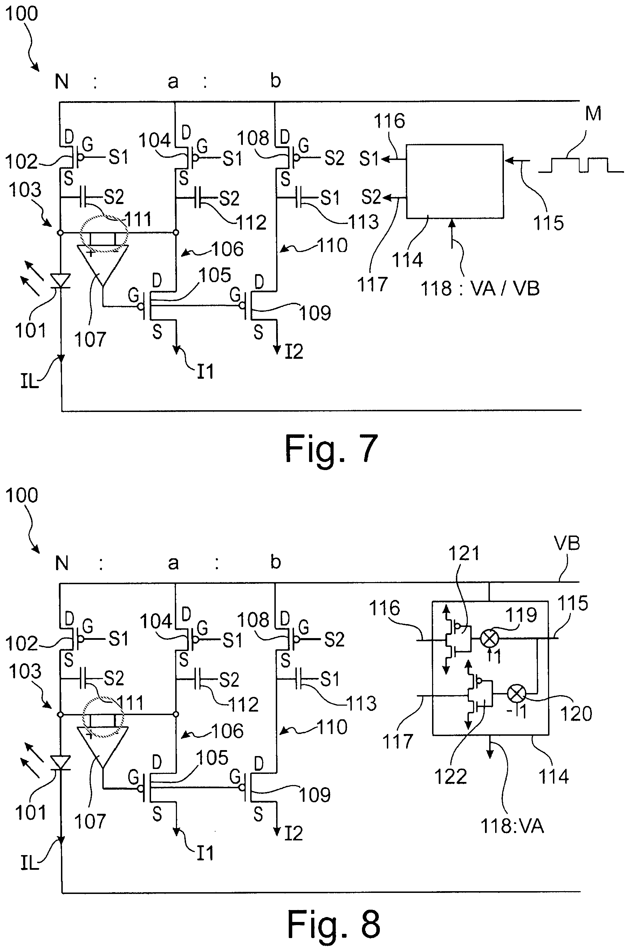

Fig. 7 zeigt eine Abwandlung der Schaltungsanordnung 100 gemäß Fig. 6. Darin ist die ansonsten identische Anordnung gemäß Fig. 6 um einen Schaltungsblock 114 zum Bilden der Steuersignale S1, S2 zum Steuern des Lastschaltelements 102 und der Messpfadschaltelemente 104, 108 erweitert.

Der Schaltungsblock 114 weist einen Eingangsanschluss 115 auf, dem das Modulationssignal M, das heißt dasjenige Signal, insbesondere Datensignal, aus dem die Steuersignale S1, S2 für das Lastschaltelement 102 und die Messpfadschaltelemente 104, 108 abgeleitet werden, zugeleitet wird. Die im Schaltungsblock 114 gebildeten Steuersignale S1, S2 werden als Ausgangssignale an Ausgangsanschlüssen 116 bzw. 117 des Schaltungsblocks 114 abgegeben.

Der Schaltungsblock 114 ist zum Zuführen einer Amplitudenstellspannung VA und zum Bilden des ersten und des zweiten Steuersignals S1, S2 mit einer von der Amplitudenstellspannung VA und/oder einer dem Schaltungsblock 114 zuführbaren Betriebsspannung VB abhängigen Amplitude eingerichtet. Die Amplitudenstellspannung VA und/oder die Betriebsspannung VB werden dem Schaltungsblock 114 über einen Stelleingang 118 zugeführt.

Fig. 8 zeigt bei ansonsten gegenüber Fig. 7 unveränderter Schaltungskonfiguration grob schematisch einige Details des inneren Aufbaus des Schaltungsblocks 114. Dieser umfasst eine erste und eine zweite Multiplikationsstufe 119 bzw. 120, deren jeweils erster Eingang mit dem Eingangsanschluss 115 zum Zuführen des Modulationssignals M verbunden ist.

Einem jeweils zweiten Eingang der Multiplikationsstufe 119 bzw. 120 wird ein logischer Pegel "+1" bzw. "-1" zugeführt, so dass an Ausgängen der Multiplikationsstufen 119 bzw. 120 zueinander komplementäre Versionen des Modulationssignals M abgegeben und je einem Eingang je einer Gegentaktendstufe 121 bzw. 122 aus je zwei mit ihren Hauptstrompfaden, das heißt Drain-Source-Strecken, in Reihenschaltung angeordneten Feldeffekttransistoren zugeführt werden.

An den Verbindungspunkten der in Reihenschaltung angeordneten Feldeffekttransistoren, die mit den Ausgangsanschlüssen 116 bzw. 117 des Schaltungsblocks 114 verbunden sind, werden dann das erste bzw. zweite Steuersignal S1, S2 abgegeben.

Wegen der Umsetzung des einpoligen Modulationssignals M in differentielle, symmetrisch ausgesteuerte Steuersignale S1, S2 in den Multiplikationsstufen 119 bzw. 120 wird der die Multiplikationsstufen 119, 120 beinhaltende Schaltungsteil auch als "Single-ended-to-differential"-Schaltung bezeichnet.

Bei der Ausführungsform gemäß Fig. 8 wird dem Schaltungsblock 114 einerseits die Betriebsspannung VB und andererseits über den Stelleingang 118 die Amplitudenstellspannung VA zugeführt. Vorzugsweise kann der Stelleingang 118 einen Masseanschluss des Schaltungsblocks 114 und die Amplitudenstellspannung VA dessen Massepotential bilden. Durch Einstellen der Amplitudenstellspannung VA bei konstanter Betriebsspannung VB kann dann eine Amplitudeneinstellung der Steuersignale S1, S2 vorgenommen werden.

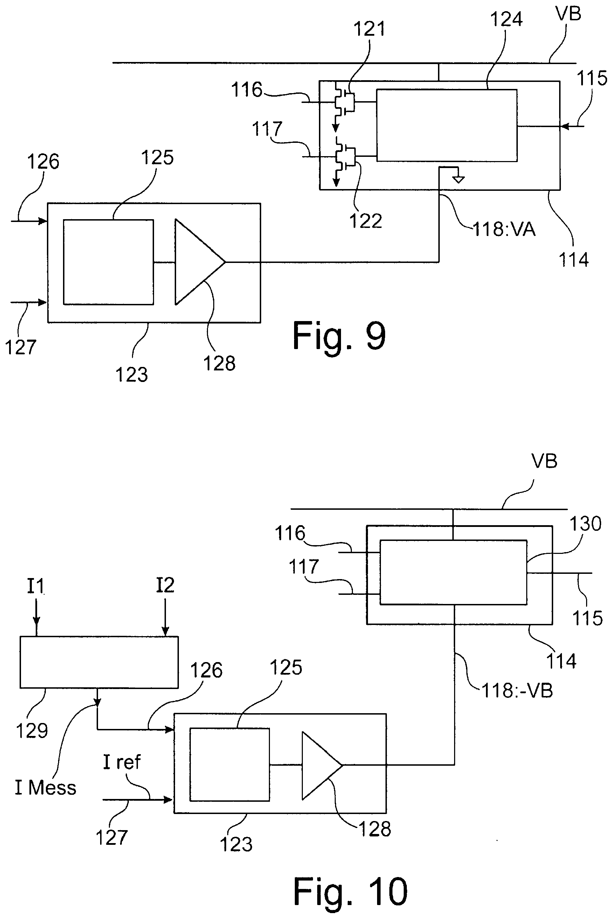

Dies ist auch in Fig. 9 angedeutet, in der eine grob schematische Darstellung einer Regeleinrichtung 123 wiedergegeben ist, die mit dem Schaltungsblock 114 gemäß Fig. 7 oder gemäß Fig. 8 zum Zuführen einer Amplitudenstellspannung VA am Stelleingang 118 einerseits und einer Betriebsspannung VB andererseits zusammenwirkt.

Dabei ist die "Single-ended-to-differential"-Schaltung 124 vereinfacht dargestellt. Die Regeleinrichtung 123 umfasst eine Vergleichsstufe 125 mit zwei Eingängen 126 bzw. 127. Einem ersten 126 dieser Eingänge 126, 127 wird ein Messstrom, dem zweiten 127 der Eingänge 126, 127 ein Referenzstrom Iref zugeleitet.

Der Messstrom und der Referenzstrom Iref werden in der Vergleichsstufe 125 verglichen. Auf der Grundlage dieses Vergleichs wird die Amplitudenstellspannung VA gebildet und eingestellt und über einen Regelverstärker 128 dem Schaltungsblock 114 zugeführt. Der Regelverstärker 128 kann dabei vorzugsweise mit einer Filtercharakteristik, insbesondere als Tiefpassfilter, ausgestaltet sein.

Als dem ersten Eingang 126 der Vergleichsstufe 125 zuzuführender Messstrom kann wahlweise, vorzugsweise bei Ausbildung der Schaltungsanordnung 100 mit nur einem ersten Messpfad 106, der erste Messstrom I1 oder eine Überlagerung, vorzugsweise Linearkombination, des ersten Messstroms I1 und des zweiten Messstroms I2 herangezogen werden.

Dieser zweite Fall ist in Fig. 10 wiedergegeben, die eine Abwandlung der Anordnung gemäß Fig. 9 mit einer grob schematischen Darstellung der Bildung eines resultierenden Messstroms IMess aus dem ersten und dem zweiten Messstrom I1 und I2 in einer Überlagerungsstufe 129 zeigt.

In der Überlagerungsstufe 129 wird der resultierende Messstrom IMess nach der Formel

$$IMess = ga * I1 + gb * I27$$

gebildet, wobei ga und gb Gewichtungsfaktoren darstellen, mit denen die Messströme I1, I2 in der Linearkombination gewichtet werden. Die Gewichtungsfaktoren ga, gb können in Abhängigkeit von den Faktoren a, b der anteiligen Paarung des Lastschaltelements 102 mit dem ersten und dem zweiten Messpfadschaltelement 104, 108 bestimmt sein.

In Fig. 10 ist der Schaltungsblock 114 vereinfacht wiedergegeben, indem die "Single-ended-to-differential"-Schaltung 124 und die 121, 122 in einem Schaltungssymbol 130 zusammengefasst sind. Der obigen Überlegung, die Amplitudenstellspannung VA betreffend, ist am Stelleingang 118 als Amplitudenstellspannung VA die negative Betriebsspannung -VB eingetragen.

Fig. 11 zeigt in grob schematischer Darstellung eine Zusammenschau der in den vorausgehenden Fig. 6 bis Fig. 10 dargestellten Schaltungsteile, das heißt insbesondere eine vollständige Schaltungsanordnung 100 gemäß den Ausführungsbeispielen gemäß Fig. 7 oder Fig. 8 mit einer Regeleinrichtung 123 gemäß den Ausführungsbeispielen gemäß Fig. 9 oder Fig. 10. Dabei ist wieder die negative Betriebsspannung -VB als Amplitudenstellspannung VA am Stelleingang 118 eingezeichnet.

In Fig. 12 und in Fig. 13 sind in grob schematischer Darstellung, dem Ausführungsbeispiel gemäß Fig.

11 folgend, zwei vollständige Ausführungsformen erfindungsgemäßer Schaltungsanordnungen wiedergegeben, und zwar einmal in einer Ausführungsform mit PMOS-Feldeffekttransistoren und zum anderen in einer Ausführungsform mit NMOS-Feldeffekttransistoren.

Dabei sind für die Schaltungselemente beider Ausführungsformen übereinstimmende Bezugszeichen gemäß den vorausgehenden Figuren verwendet. Der Polung der PMOS-Feldeffekttransistoren bzw. der NMOS-Feldeffekttransistoren entsprechend sind auch die Spannungspotentiale in den Schaltungsanordnungen gewählt.

In Fig. 12 ist außerdem der vereinfachte Fall einer Paarung des Lastpfades 103 und der Messpfade 106, 110 im Verhältnis N:1:1 angenommen worden. Die Überlagerungsstufe 129 vereinfacht sich dadurch bei gleicher Gewichtung der Messströme I1, I2 zu einer einfachen Stromadditionseinrichtung oder, wie in Fig. 13 dargestellt, zu einem einfachen Stromknoten.

In Fig. 12 ist außerdem eine Referenzstromquelle 131 zum Liefern des Referenzstroms Iref an den zweiten Eingang 127 der Vergleichsstufe 125 eingetragen.

Ferner ist in den Ausführungsformen gemäß Fig. 12 und Fig. 13 zum Lastschaltelement 102, zum ersten Messpfadschaltelement 104 und zum zweiten Messpfadschaltelement 108 je eine mit dem betreffenden der Schaltelemente 102, 104 bzw. 108 in vorgebbarem Paarungsverhältnis gepaarte Konstantstromquelle 132, 133 bzw. 134 in Parallelschaltung angeordnet.

Insbesondere sind die Konstantstromquellen 132, 133, 134 in einem gleichen oder ähnlichen Paarungsverhältnis zueinander dimensioniert wie das Lastschaltelement 102, das erste Messpfadschaltelement 104 und das zweite Messpfadschaltelement 108 untereinander. Die die Konstantstromquellen 132, 133, 134 geben dabei einen Minimalstrom im Lastpfad 103 bzw. den Messpfaden 106, 110 vor.

Zusammenfassend wird somit das Lastschaltelement 102, hier ein MOSFET, das in Serie mit der Laserdiode 101 liegt und deren Modulationsstrom liefert, - gegebenenfalls anteilig - durch ein oder mehrere Messpfadschaltelemente 104, 108 nachgeahmt bzw. gepaart, die einen oder mehrere in festem Verhältnis zum Modulationsstrom stehende Messströme I1, I2 erzeugen, die zur Bestimmung eines mittleren Modulationsstroms dienen.

Dazu wird mit Hilfe des Hilfsreglers 107 und Spannungsstellelementen 105, 109, zum Beispiel Kaskode-Transistoren, die Spannung über dem Lastschaltelement 102 zwecks Paarung auf die Spannung über den Messpfadschaltelementen 104, 108 übertragen. Damit liefern diese, wenn sie als, gegebenenfalls anteilig, gepaarte Bauteile angelegt sind, zum Laststrom, das heißt Laserstrom IL, in definiertem Verhältnis N:a:b stehende Messströme I1, I2.

Zur Begriffsbestimmung sei wiederholt, dass es sich bei dem Modulationsstrom um den Wechselstromanteil im Laststrom IL handelt, wohingegen mit dem Begriff Modulationssignal M dasjenige Signal, insbesondere Datensignal, bezeichnet ist, aus dem die Steuersignale S1, S2 für das Lastschaltelement 102 und die Messpfadschaltelemente 104, 108 abgeleitet werden.

Zwei solchermaßen gepaarte Messpfade 106, 110 können dabei komplementär angesteuert werden, so dass das resultierende Summensignal IMess vergleichsweise langsam variiert und kaum vom Modulationssignal M abhängt. Es kann aber gegebenenfalls auch nur ein zum Laserstrompfad 103 gepaarter Messpfad verwendet werden.

Erfindungsgemäß wird der so bestimmte Laserstrom IL bzw. Laserstrombruchteil I1, I2 bzw. IMess mit einem Referenzstrom Iref verglichen und die Ansteuerung der Schaltelemente 102, 104, 108 so nachgeregelt, dass sich der gewünschte Wert einstellt.

Zur Erzeugung einer entsprechenden variablen Ansteuerung der Schaltelemente 102, 104, 108 wird ein mit variabler Steuer- oder Betriebsspannung VA bzw. VB betriebener Schaltungsblock 114 verwendet, von dem ein in seiner Amplitude einstellbares Steuersignal S1 oder zwei in ihrer Amplitude einstellbare komplementäre Steuersignale S1, S2 erzeugt werden können.

## Bezugszeichenliste

| | |
|---|---|
| 100 | Schaltungsanordnung |
| 101 | Lastelement, insbesondere Laserdiode |
| 102 | Lastschaltelement, insbesondere Feldeffekttransistor (MOSFET) |
| 103 | Lastpfad, insbesondere Laserstrompfad |
| 104 | erstes Messpfadschaltelement, insbesondere Feldeffekttransistor (MOSFET) |
| 105 | erstes Spannungsstellelement, insbesondere Feldeffekttransistor (MOSFET) |
| 106 | erster Messpfad |
| 107 | Hilfsregler, insbesondere Operationsverstärker |
| 108 | zweites Messpfadschaltelement, insbesondere Feldeffekttransistor (MOSFET) |
| 109 | zweites Spannungsstellelement, insbesondere Feldeffekttransistor (MOSFET) |
| 110 | zweiter Messpfad |
| 111 | erstes kapazitives Bauelement |
| 112 | zweites kapazitives Bauelement |
| 113 | drittes kapazitives Bauelement |
| 114 | Schaltungsblock |
| 115 | Eingangsanschluss des Schaltungsblocks 114 |
| 116 | erster Ausgangsanschluss des Schaltungsblocks 114 für erstes Steuersignal S1 |
| 117 | zweiter Ausgangsanschluss des Schaltungsblocks 114 für zweites Steuersignal S2 |
| 118 | Stelleingang des Schaltungsblocks 114 für Amplitudenstellspannung bzw. Steuerspannung VA bzw. für Betriebsspannung VB |

| | | |
|---|---|---|
| 119 | erste Multiplikationsstufe des Schaltungsblocks 114 |
| 120 | zweite Multiplikationsstufe des Schaltungsblocks 114 |
| 121 | erste Gegentaktendstufe des Schaltungsblocks 114 |
| 122 | zweite Gegentaktendstufe des Schaltungsblocks 114 |
| 123 | Regeleinrichtung |
| 124 | single-ended-to-differential-Schaltung des Schaltungsblocks 114 |
| 125 | Vergleichsstufe der Regeleinrichtung 123 |
| 126 | erster Eingang der Vergleichsstufe 125 |
| 127 | zweiter Eingang der Vergleichsstufe 125 |
| 128 | Regelverstärker der Regeleinrichtung 123 |
| 129 | Überlagerungsstufe |
| 130 | Schaltungssymbol, in dem erste Gegentaktendstufe 121, zweite Gegentaktendstufe 122 und single-ended-to-differential-Schaltung 124 zusammengefasst sind |
| 131 | Referenzstromquelle |
| 132 | Konstantstromquelle |
| 133 | Konstantstromquelle |
| 134 | Konstantstromquelle |
| 200 | Laserdiode |
| 201 | Feldeffekttransistor, insbesondere MOSFET |
| 202 | Betriebsspannungsanschluss |
| 203 | Bezugspotenzial oder Referenzpotenzial, insbesondere Masse oder Nullpotenzial oder Si-gnalerde |
| 204 | Ansteuerungsschaltung für Feldeffekttransis-tor 201 |
| 205 | Gleichspannungswandler |
| 206 | Eingang des Gleichspannungswandlers 205 |
| 207 | Ausgang des Gleichspannungswandlers 205 |
| a | Faktor der, insbesondere anteiligen, Paarung von Lastschaltelement 102 und erstem Messpfadschaltelement 104 |
| b | Faktor der, insbesondere anteiligen, Paarung von Lastschaltelement 102 und zweitem Messpfadschaltelement 108 |
| D | Drainanschluss |
| G | Gateanschluss |
| ga | Gewichtungsfaktor für ersten Messstrom I1 in resultierendem Messstrom IMess |
| gb | Gewichtungsfaktor für zweiten Messstrom I2 in resultierendem Messstrom IMess |
| I1 | erster Messstrom |
| I2 | zweiter Messstrom |
| IL | Laststrom, insbesondere Laserstrom |
| IMess | resultierender Messstrom |
| Iref | Referenzstrom |
| M | Modulationssignal |
| N | Faktor der, insbesondere anteiligen, Paarung von Lastschaltelement 102 und Messpfadschaltelement(en) 104, 108 |
| S | Sourceanschluss |
| S1 | erstes Steuersignal |
| S2 | zweites, insbesondere zum ersten Steuersignal S1 komplementäres, Steuersignal |
| VA | Amplitudenstellspannung bzw. Steuerspannung |
| VB | Betriebsspannung |
| VB1 | erste Betriebsspannung |
| VB2 | zweite Betriebsspannung |
| VF | Vorwärtsspannung an Laserdiode 200 |
| VGS | Gate-Source-Spannung an Feldeffekttransistor 201 |
| Vsum | in Summe nötiger Spannungsabfall |
| Vt | Schwellenspannung |
| ΔV | Modulations-Wechselspannung bzw. Span-nung zur Aussteuerung des Feldeffekttransis-tors 201 |

**Patentansprüche**

1.  Schaltungsanordnung (100) zum Steuern und Messen eines elektrischen Laststroms (IL) in mindestens einem Lastelement (101), aufweisend

    - ein in Serie mit dem mindestens einen Lastelement (101) angeordnetes Lastschaltelement (102), das zum Steuern des Laststroms (IL) eingerichtet ist,
    - einen ersten Messpfad (106), aufweisend ein mit dem Lastschaltelement (102) in vorgebbarem Paarungsverhältnis (N:a; N:1) gepaartes und durch ein mit dem Lastschaltelement (102) gemeinsames erstes Steuersignal (S1) gesteuertes erstes Messpfadschaltelement (104) und ein mit dem ersten Messpfadschaltelement (104) in Serie angeordnetes erstes Spannungsstellelement (105),
    - einen Hilfsregler (107) zum Steuern des ersten Spannungsstellelements (105) in Abhängigkeit von einer Differenz der Spannungen über dem Lastschaltelement (102) und über dem ersten Messpfadschaltelement (104) derart, dass die Spannung über dem Messpfadschaltelement (104) in Abhängigkeit von der Spannung über dem Lastschaltelement (102) kontrolliert wird, so dass ein zum Laststrom (IL) im Paarungsverhältnis (N:a; N:1) proportionaler erster Messstrom (I1) durch das erste Messpfadschaltelement (104) und durch das erste Spannungsstellelement (105) erzeugt wird,

    **gekennzeichnet durch** einen zweiten Messpfad (110), aufweisend ein mit dem Lastschalt-element (102) in vorgebbarem Paarungsver-hältnis (N:b; N:1) gepaartes zweites Messpfadschaltelement (108) und ein mit dem zweiten Messpfadschaltelement (108) in Serie angeordnetes zweites Spannungsstellelement (109), wobei das zweite Messpfadschaltelement (108) zum Steuern **durch** ein zum ersten Steuersignal (S1) komplementäres zweites Steuersignal (S2) und das zweite Spannungsstellelement (109) zum mit dem ersten Spannungsstellelement (105) gemeinsamen Steuern **durch** den Hilfsregler (107) eingerichtet ist, so dass ein zweiter Messstrom (I2) **durch** das zweite Messpfadschaltelement (108) und **durch** das zweite Spannungsstellelement (109) erzeugt wird, dessen Variation zu derjenigen des Laststroms (IL) umgekehrt proportional ist.

2. Schaltungsanordnung gemäß Anspruch 1, **dadurch gekennzeichnet, dass** das Lastschaltelement (102), das erste Messpfadschaltelement (104) und/oder das zweite Messpfadschaltelement (108) an Ausgangsanschlüssen (S) einseitig mit je einem kapazitiven Bauelement (111, 112, 113) verbunden sind, das anderseitig zum Zuführen eines zum dem betreffenden Schaltelement zugeführten Steuersignal (S1; S2) komplementären Signals (S2; S1) eingerichtet ist.

3. Schaltungsanordnung gemäß Anspruch 1 oder 2, **gekennzeichnet durch** einen Schaltungsblock (114) zum Bilden des ersten Steuersignals (S1) und wahlweise zusätzlich des zweiten Steuersignals (S2) zum Steuern des Lastschaltelements (102), des ersten Messpfadschaltelements (104) und/oder des zweiten Messpfadschaltelements (108), wobei der Schaltungsblock (114) zum Zuführen einer Amplitudenstellspannung (VA) und zum Bilden des ersten Steuersignals (S1) und wahlweise zusätzlich des zweiten Steuersignals (S2) mit einer von der Amplitudenstellspannung (VA) und/oder einer dem Schaltungsblock (114) zuführbaren Betriebsspannung (VB) abhängigen Amplitude eingerichtet ist.

4. Schaltungsanordnung gemäß Anspruch 3, **dadurch gekennzeichnet,**

   - **dass** der Schaltungsblock (114) mit CMOS-Bauelementen ausgebildet ist,
   - **dass** die Amplitudenstellspannung (VA) zumindest nahezu gleich einer zum Betreiben der CMOS-Bauelemente vorgesehenen Betriebsspannung (VB) ist und
   - **dass** der Schaltungsblock (114) dazu eingerichtet ist, die Amplitudenstellspannung (VA) als Betriebsspannung (VB) zugeführt zu erhalten und das erste Steuersignal (S1) und wahlweise zusätzlich das zweite Steuersignal (S2) mit einer zur Betriebsspannung (VB) proportionalen Ausgangsamplitude zu bilden.

5. Schaltungsanordnung gemäß Anspruch 3 oder 4, **dadurch gekennzeichnet, dass** der Schaltungsblock (114) mit einer Einrichtung (124; 130) zum Zuführen eines unsymmetrischen Modulationssignals (M) und zum daraus Bilden des ersten Steuersignals (S1) und wahlweise zusätzlich des zweiten Steuersignals (S2) als zumindest nahezu symmetrische Signale oder Gegentaktsignale ausgebildet ist.

6. Schaltungsanordnung gemäß mindestens einem der Ansprüche 3 bis 5, **gekennzeichnet durch** eine Regeleinrichtung (123), die eingerichtet ist zum

   - Zuführen des ersten Messstroms (I1) und wahlweise des zweiten Messstroms (I2),
   - Auswerten des ersten Messstroms (I1) und wahlweise des zweiten Messstroms (I2) und
   - auf dieser Grundlage Bilden und Einstellen der dem Schaltungsblock (114) zuführbaren Amplitudenstellspannung (VA) und/oder Betriebsspannung (VB) derart, dass ein Zielwert des ersten Messstroms (I1) oder wahlweise einer Linearkombination des ersten Messstroms (I1) und zweiten Messstroms (I2) und damit ein Zielwert des Modulationsstroms, das heißt des **durch** das erste Steuersignal (S1) modulierten Laststroms (IL), erreicht wird.

7. Schaltungsanordnung gemäß Anspruch 6, **dadurch gekennzeichnet, dass** die Regeleinrichtung (123) zum Bilden eines Summensignals (IMess) aus der Summe des ersten (I1) und zweiten (I2) Messstroms eingerichtet ist, wobei das Summensignal (IMess) eine gegenüber dem ersten (I1) und dem zweiten (I2) Messstrom geringere und/oder langsamere zeitliche Variation aufweist.

8. Schaltungsanordnung gemäß mindestens einem der Ansprüche 1 bis 7, **dadurch gekennzeichnet, dass** zum Lastschaltelement (102) und/oder zum ersten Messpfadschaltelement (104) und/oder zum zweiten Messpfadschaltelement (108) je eine mit dem betreffenden der Schaltelemente (102; 104; 108) in vorgebbarem Paarungsverhältnis gepaarte Konstantstromquelle (132; 133; 134) in Parallelschaltung angeordnet ist, wobei insbesondere die Konstantstromquellen (132; 133; 134) in einem gleichen oder ähnlichen Paarungsverhältnis (N:a:b; N:1:1) zueinander dimensioniert sind wie das Lastschaltelement (102), das erste Messpfadschaltelement (104) und/oder das zweite Messpfadschaltelement (108) untereinander.

9. Schaltungsanordnung gemäß mindestens einem der Ansprüche 1 bis 8, **dadurch gekennzeichnet, dass** das mindestens eine Lastelement (101) als mindestens eine Laserdiode ausgebildet ist.

10. Verfahren zum Steuern und Messen eines elektrischen Laststroms (IL) in mindestens einem Lastelement (101), insbesondere in mindestens einer Laserdiode, wobei

- der Laststrom (IL) mittels eines in Serie mit dem mindestens einen Lastelement (101) angeordneten Lastschaltelements (102) gesteuert wird,

- ein erstes Messpfadschaltelement (104) mit dem Lastschaltelement (102) in vorgebbarem Paarungsverhältnis (N:a; N:1) gepaart und durch ein mit dem Lastschaltelement (102) gemeinsames erstes Steuersignal (S1) gesteuert wird,

- ein mit dem ersten Messpfadschaltelement (104) in einem ersten Messpfad (106) in Serie angeordnetes erstes Spannungsstellelement (105) mittels eines Hilfsreglers (107) in Abhängigkeit von einer Differenz der Spannungen über dem Lastschaltelement (102) und über dem ersten Messpfadschaltelement (104) derart gesteuert wird, dass die Spannung über dem Messpfadschaltelement (104) in Abhängigkeit von der Spannung über dem Lastschaltelement (102) kontrolliert wird, so dass ein zum Laststrom (IL) im Paarungsverhältnis (N:a; N:1) proportionaler erster Messstrom (I1) durch das erste Messpfadschaltelement (104) und durch das erste Spannungsstellelement (105) erzeugt wird,

**dadurch gekennzeichnet, dass** ein mit dem Lastschaltelement (102) in vorgebbarem Paarungsverhältnis (N:b; N:1) gepaartes zweites Messpfadschaltelement (108) durch ein zum ersten Steuersignal (S1) komplementäres zweites Steuersignal (S2) gesteuert wird und dass ein mit dem zweiten Messpfadschaltelement (108) in einem zweiten Messpfad (110) in Serie angeordnetes zweites Spannungsstellelement (109) mittels des Hilfsreglers (107) mit dem ersten Spannungsstellelement (105) gemeinsam derart gesteuert wird, dass ein zweiter Messstrom (I2) durch das zweite Messpfadschaltelement (108) und durch das zweite Spannungsstellelement (109) erzeugt wird, dessen Variation zu derjenigen des Laststroms (IL) umgekehrt proportional ist.

11. Verfahren gemäß Anspruch 10, **dadurch gekennzeichnet, dass** das erste Steuersignal (S1) und wahlweise zusätzlich das zweite Steuersignal (S2) zum Steuern des Lastschaltelements (102), des ersten Messpfadschaltelements (104) und/oder des zweiten Messpfadschaltelements (108) durch einen Schaltungsblock (114) gebildet wird, wobei durch den Schaltungsblock (114) eine Amplitudenstellspannung (VA) zugeführt und das erste Steuersignal (S1) sowie wahlweise zusätzlich das zweite Steuersignal (S2) mit einer von der Amplitudenstellspannung (VA) und/oder einer dem Schaltungsblock (114) zuführbaren Betriebsspannung (VB) abhängigen Amplitude gebildet wird.

12. Verfahren gemäß Anspruch 11, **dadurch gekennzeichnet, dass** der Schaltungsblock (114) dazu eingerichtet ist, die Amplitudenstellspannung (VA) als Betriebsspannung (VB) zugeführt zu erhalten und das erste Steuersignal (S1) und wahlweise zusätzlich das zweite Steuersignal (S2) mit einer zur Betriebsspannung (VB) proportionalen Ausgangsamplitude zu bilden.

13. Verwendung einer Schaltungsanordnung (100) gemäß mindestens einem der Ansprüche 1 bis 9 und/oder eines Verfahrens gemäß mindestens einem der Ansprüche 10 bis 12 zum Treiben mindestens eines Lastelements (101) in der optischen Datenübertragung, insbesondere in mindestens einem aktiv-optischen Kabel (AOC).

**Claims**

1. A circuit arrangement (100) for controlling and measuring an electrical load current (IL) in at least one load element (101), comprising

   - a load circuit element (102) arranged in series with the at least one load element (101), said load circuit element (102) set up to control the load current (IL),
   - a first measurement path (106) comprising a first measurement path circuit element (104), said first measurement path circuit element (104) paired with the load circuit element (102) in a predefinable pairing ratio (N:a; N:1) and controlled by a first control signal (S1) in common with the load circuit element (102), and a first voltage setting element (105) arranged in series with the first measurement path circuit element (104),
   - an auxiliary controller (107) for controlling the first voltage setting element (105) depending on a difference of the voltages across the load circuit element (102) and across the first measurement path circuit element (104) such that the voltage across the measurement path circuit element (104) is controlled depending on the voltage across the load circuit element (102), so that a first measurement current (I1) proportional to the load current (IL) in the pairing ratio (N:a; N:1) is generated by the first measurement path circuit element (104) and by the first voltage setting element (105),

   **characterized by** a second measurement path (110) comprising a second measurement path circuit element (108) paired with the load circuit element (102) in a predefinable pairing ratio (N:b; N:1) and a second voltage setting element (109) arranged in series with the second measurement path circuit element (108), wherein the second measurement path circuit element (108) is set up for controlling by a second control signal (S2) complementary to the first control signal (S1) and the second voltage setting element (109) is set up for controlling in common with the first voltage setting element (105) by the auxiliary controller (107) such that a second measurement current (I2) is generated by the second measurement path circuit element (108) and by the second voltage setting element (109), the variation of which is inversely proportional to that of the load current (IL).

2. The circuit arrangement according to claim 1, **characterized in that** the load circuit element (102), the first measurement path circuit element (104) and/or the second measurement path circuit element (108) are connected at output connections (S) on the one side with a respective capacitive component (111, 112, 113) which is set up on the other side for supplying a signal (S2; S1) complementary to the control signal (S1; S2) supplied to the relevant circuit element.

3. The circuit arrangement according to claim 1 or 2, **characterized by** a circuit block (114) for forming the first control signal (S1) and optionally additionally the second control signal (S2) for controlling the load circuit element (102), the first measurement path circuit element (104) and/or the second measurement path circuit element (108), wherein the circuit block (114) for supplying an amplitude setting voltage (VA) and for forming the first control signal (S1) and optionally additionally the second control signal (S2) is set up with an amplitude depending on the amplitude setting voltage (VA) and/or on an operating voltage (VB) suppliable to the circuit block (114).

4. The circuit arrangement according to claim 3, **characterized in**

   - **that** the circuit block (114) is configured with CMOS components,
   - **that** the amplitude setting voltage (VA) is at least almost equal to an operating voltage (VB) provided for operating the CMOS components, and
   - **that** the circuit block (114) is set up for receiving the amplitude setting voltage (VA) supplied as the operating voltage (VB) and for forming the first control signal (S1) and optionally additionally the second control signal (S2) with an output amplitude proportional to the operating voltage (VB).

5. The circuit arrangement according to claim 3 or 4, **characterized in that** the circuit block (114) is configured with a device (124; 130) for supplying an asymmetric modulation signal (M) and for forming therefrom the first control signal (S1) and optionally additionally the second control signal (S2) as at least almost symmetrical signals or push-pull signals.

6. The circuit arrangement according to at least one of claims 3 to 5, **characterized by** a control device (123) which is set up for

   - supplying the first measurement current (I1) and optionally the second measurement current (I2),
   - evaluating the first measurement current (I1) and optionally the second measurement current (I2), and
   - on this basis, forming and setting the amplitude setting voltage (VA) and/or operating voltage (VB) suppliable to the circuit block (114) such that a target value of the first measurement current (I1) or optionally of a linear combination of the first measurement current (I1) with the second measurement current (I2) and thus a target value of the modulation current, that is of the load current (IL) modulated by the first control signal (S1), is achieved.

7. The circuit arrangement according to claim 6, **characterized in that** the control device (123) for forming a summation signal (IMess) is set up from the sum of the first (I1) and second (I2) measurement currents, wherein the summation signal (IMess) has a lower and/or slower temporal variation with respect to the first (I1) and the second (I2) measurement current.

8. The circuit arrangement according to at least one of claims 1 to 7, **characterized in that** a respective constant current source (132; 133; 134) is arranged in parallel to the load circuit element (102) and/or to the first measurement path circuit element (104) and/or to the second measurement path circuit element (108), said respective constant current source (132; 133; 134) paired with the relevant one of the circuit elements (102; 104; 108) in a predefinable pairing ratio, wherein in particular the constant current sources (132; 133; 134) are dimensioned to one another in a same or similar pairing ratio (N:a:b; N:1:1) as the load circuit element (102), the first measurement path circuit element (104) and/or the second measurement path circuit element (108) are to one another.

9. The circuit arrangement according to at least one of claims 1 to 8, **characterized in that** the at least one load element (101) is configured as at least one laser diode.

10. A method for controlling and measuring an electrical load current (IL) in at least one load element (101), in particular in at least one laser diode, wherein

- the load current (IL) is controlled by means of a load circuit element (102) arranged in series with the at least one load element (101),
- a first measurement path circuit element (104) is paired with the load circuit element (102) in a predefinable pairing ratio (N:a; N:1) and is controlled by a first control signal (S1) in common with the load circuit element (102),
- a first voltage setting element (105) arranged in series with the first measurement path circuit element (104) in a first measurement path (106) is controlled by means of an auxiliary controller (107) depending on a difference of the voltages across the load circuit element (102) and across the first measurement path circuit element (104) is controlled such that the voltage across the measurement path circuit element (104) is controlled depending on the voltage across the load circuit element (102), so that a first measurement current (11) proportional to the load current (IL) in the pairing ratio (N:a; N:1) is generated by the first measurement path circuit element (104) and by the first voltage setting element (105),

**characterized in that** a second measurement path circuit element (108) paired with the load circuit element (102) in a predefinable pairing ratio (N:b; N:1) is controlled by a second control signal (S2) complementary to the first control signal (S1) and **in that** a second voltage setting element (109) arranged in series with the second measurement path circuit element (108) in a second measurement path (110) is controlled by means of the auxiliary controller (107) in common with the first voltage setting element (105) such that a second measurement current (12) is generated by the second measurement path circuit element (108) and by the second voltage setting element (109), the variation of which is inversely proportional to that of the load current (IL).

11. The method according to claim 10, **characterized in that** the first control signal (S1) and optionally additionally the second control signal (S2) for controlling the load circuit element (102), the first measurement path circuit element (104) and/or the second measurement path circuit element (108) is formed by a circuit block (114), wherein an amplitude setting voltage (VA) is supplied by the circuit block (114) and the first control signal (S1) and optionally additionally the second control signal (S2) is formed with an amplitude depending on the amplitude setting voltage (VA) and/or on an operating voltage (VB) suppliable to the circuit block (114).

12. The method according to claim 11, **characterized in that** the circuit block (114) is set up for receiving the amplitude setting voltage (VA) supplied as the operating voltage (VB) and for forming the first control signal (S1) and optionally additionally the second control signal (S2) with an output amplitude proportional to the operating voltage (VB).

13. A use of a circuit arrangement (100) according to at least one of claims 1 to 9 and/or of a method according to at least one of claims 10 to 12 for driving at least one load element (101) in the optical data transmission, in particular in at least one active optical cable (AOC).

**Revendications**

1. Circuit (100) de commande et de mesure d'un courant électrique de charge (IL) dans au moins un élément de charge (101), comportant

- un élément de commutation de charge (102) disposé en série avec ledit au moins un élément de charge (101) et adapté pour commander le courant de charge (IL),
- un premier chemin de mesure (106) comportant un premier élément de commutation de chemin de mesure (104) apparié avec l'élément de commutation de charge (102) selon un rapport d'appariement (N:a ; N:1) prédéterminable et commandé par un premier signal de commande (S1) commun avec l'élément de commutation de charge (102), et un premier élément de réglage de tension (105) disposé en série avec le premier élément de commutation de chemin de mesure (104),
- un régulateur auxiliaire (107) pour commander le premier élément de réglage de tension (105) en fonction d'une différence des tensions aux bornes de l'élément de commutation de charge (102) et aux bornes du premier élément de commutation de chemin de mesure (104) de telle sorte que la tension aux bornes de l'élément de commutation de chemin de mesure (104) soit commandée en fonction de la tension aux bornes de l'élément de commutation de charge (102) de telle sorte qu'un premier courant de mesure (I1) proportionnel au courant de charge (IL) dans le rapport d'appariement (N:a ; N:1) est généré par le premier élément de commutation de chemin de mesure (104) et par le premier élément de réglage de tension (105),

**caractérisé par** un deuxième chemin de mesure (110) comportant un deuxième élément de commutation de chemin de mesure (108) apparié avec l'élément de commutation de charge (102) selon un rapport d'appariement (N:b ; N:1) prédéterminable et un deuxième élément de réglage de tension (109) disposé en série avec le deuxième élément de commutation de chemin de mesure (108), le deuxième élément de commutation de chemin de mesure (108) étant conçu pour commander par un deuxième signal de commande (S2) complémentaire du premier signal de commande (S1) et le deuxième élément de réglage de tension (109) étant conçu pour commander conjointement avec le premier élément de réglage de tension (105) par le régulateur auxiliaire (107), de sorte qu'un deuxième courant de mesure (I2) est généré par le deuxième élément de commutation de chemin de mesure (108) et par le deuxième élément de réglage de tension (109), dont la variation est inversement proportionnelle à celle du courant de charge (IL).

2. Circuit selon la revendication 1, **caractérisé en ce que** l'élément de commutation de charge (102), le premier élément de commutation de chemin de mesure (104) et/ou le deuxième élément de commutation de chemin de mesure (108) sont reliés, au niveau de bornes de sortie (S), d'un côté chacun à un composant capacitif (111, 112, 113) qui est conçu de l'autre côté pour amener un signal (S2 ; S1) complémentaire au signal de commande (S1 ; S2) amené à l'élément de commutation concerné.

3. Circuit selon la revendication 1 ou 2, **caractérisé par** un bloc de circuit (114) pour former le premier signal de commande (S1) et, en option, en plus le deuxième signal de commande (S2) pour commander l'élément de commutation de charge (102), le premier élément de commutation de chemin de mesure (104) et/ou le deuxième élément de commutation de chemin de mesure (108), le bloc de circuit (114) étant conçu pour fournir une tension de réglage d'amplitude (VA) et pour former le premier signal de commande (S1) et, en option, en plus le deuxième signal de commande (S2) avec une amplitude qui dépend de la tension de réglage d'amplitude (VA) et/ou d'une tension de fonctionnement (VB) pouvant être fournie au bloc de circuit (114).

4. Circuit selon la revendication 3, **caractérisé en ce**

    - **que** le bloc (114) est réalisé avec des composants CMOS,
    - **que** la tension de réglage d'amplitude (VA) est au moins presque égale à une tension de fonctionnement (VB) prévue pour le fonctionnement des composants CMOS, et
    - **que** le bloc de circuit (114) est conçu pour recevoir la tension de réglage d'amplitude (VA) en tant que tension de fonctionnement (VB) et pour former le premier signal de commande (S1) et, en option, en plus le deuxième signal de commande (S2) avec une amplitude de sortie proportionnelle à la tension de fonctionnement (VB).

5. Circuit selon la revendication 3 ou 4, **caractérisé en ce que** le bloc de circuit (114) est réalisé avec un dispositif (124 ; 130) pour amener un signal de modulation asymétrique (M) et pour former à partir de celui-ci le premier signal de commande (S1) et, en option, en plus le deuxième signal de commande (S2) sous forme de signaux au moins presque symétriques ou de signaux push-pulls.

6. Circuit selon au moins une des revendications 3 à 5, **caractérisé par** un dispositif de régulation (123), qui est conçu pour

    - fournir le premier courant de mesure (I1) et, en option, le deuxième courant de mesure (I2),
    - évaluer le premier courant de mesure (I1) et, en option, le deuxième courant de mesure (I2), et
    - sur cette base, former et régler la tension de réglage d'amplitude (VA) et/ou tension de fonctionnement (VB) pouvant être amenées au bloc de circuit (114) de telle sorte qu'une valeur cible du premier courant de mesure (I1) ou, en option, d'une combinaison linéaire du premier courant de mesure (I1) et du deuxième courant de mesure (I2), et donc une valeur cible du courant de modulation, c'est-à-dire du courant de charge (IL) modulé par le premier signal de commande (S1), soit atteinte.

7. Circuit selon la revendication 6, **caractérisé en ce que** le dispositif de régulation (123) est conçu pour former un signal de somme (IMess) à partir de la somme du premier (I1) et du deuxième (I2) courant de mesure, le signal de somme (IMess) présentant une variation temporelle plus faible et/ou plus lente par rapport au premier (I1) et au deuxième (I2) courant de mesure.

8. Circuit selon au moins une des revendications 1 à 7, **caractérisé en ce que**, en parallèle avec l'élément de commutation de charge (102) et/ou avec le premier élément de commutation de chemin de mesure (104) et/ou avec le deuxième élément de commutation de chemin de mesure (108), une source de courant constant respective (132 ; 133 ; 134), appariée avec l'élément de commutation concerné (102 ; 104 ; 108) dans un rapport d'appariement prédéterminable, est disposée, en particulier les sources de courant constant (132 ; 133 ; 134) étant dimensionnées entre eux dans un rapport d'appariement (N:a:b ; N:1:1) égal ou similaire à l'élément de commutation de charge (102), le premier élément de commutation de chemin de mesure (104) et/ou le deuxième élément de commutation de chemin de mesure (108) entre eux.

9. Circuit selon au moins une des revendications 1 à 8, **caractérisé en ce que** l'au moins un élément de charge (101) est conçu comme au moins une diode laser.

10. Procédé de commande et de mesure d'un courant électrique de charge (IL) dans au moins un élément de charge (101), en particulier dans au moins une diode laser, ou

- le courant de charge (IL) est commandé au moyen d'un élément de commutation de charge (102) disposé en série avec ledit au moins un élément de charge (101),
- un premier élément de commutation de chemin de mesure (104) est apparié avec l'élément de commutation de charge (102) selon un rapport d'appariement (N:a ; N:1) prédéterminable et est commandé par un premier signal de commande (S1) commun avec l'élément de commutation de charge (102),
- un premier élément de réglage de tension (105) disposé en série avec le premier élément de commutation de chemin de mesure (104) dans un premier chemin de mesure (106) est commandé au moyen d'un régulateur auxiliaire (107) en fonction d'une différence des tensions aux bornes de l'élément de commutation de charge (102) et aux bornes du premier élément de commutation de chemin de mesure (104) de telle sorte que la tension aux bornes de l'élément de commutation de chemin de mesure (104) est commandée en fonction de la tension aux bornes de l'élément de commutation de charge (102) de telle sorte qu'un premier courant de mesure (I1) proportionnel au courant de charge (IL) dans le rapport d'appariement (N:a ; N:1) est généré par le premier élément de commutation de chemin de mesure (104) et par le premier élément de réglage de tension (105), **caractérisé en ce qu'** un deuxième élément de commutation de chemin de mesure (108) apparié avec l'élément de commutation de charge (102) selon un rapport d'appariement (N:b ; N:1) prédéterminable est commandé par un deuxième signal de commande (S2) complémentaire au premier signal de commande (S1) et **qu'** un deuxième élément de réglage de tension (109) disposé en série avec le deuxième élément de commutation de chemin de mesure (108) dans un deuxième chemin de mesure (110) est commandé au moyen du régulateur auxiliaire (107) conjointement avec le premier élément de réglage de tension (105) de telle sorte qu'un deuxième courant de mesure (I2) est généré par le deuxième élément de commutation de chemin de mesure (108) et par le deuxième élément de réglage de tension (109), dont la variation est inversement proportionnelle à celle du courant de charge (IL).

11. Procédé selon la revendication 10, **caractérisé en ce que** le premier signal de commande (S1) et, en option, en plus le deuxième signal de commande (S2) pour commander l'élément de commutation de charge (102), le premier élément de commutation de chemin de mesure (104) et/ou le deuxième élément de commutation de chemin de mesure (108) est formé par un bloc de circuit (114), une tension de réglage d'amplitude (VA) étant amenée par le bloc de circuit (114), et le premier signal de commande (S1) et, en option, en plus le deuxième signal de commande (S2) est formé avec une amplitude dépendant de la tension de réglage d'amplitude (VA) et/ou d'une tension de fonctionnement (VB) pouvant être amenée au bloc de circuit (114).

12. Procédé selon la revendication 11, **caractérisé en ce que** le bloc de circuit (114) est conçu pour recevoir la tension de réglage d'amplitude (VA) en tant que tension de fonctionnement (VB) et pour former le premier signal de commande (S1) et, en option, en plus le deuxième signal de commande (S2) avec une amplitude de sortie proportionnelle à la tension de fonctionnement (VB).

13. Utilisation d'un circuit (100) selon au moins une des revendications 1 à 9 et/ou d'un procédé selon au moins une des revendications 10 à 12 pour piloter au moins un élément de charge (101) dans la transmission optique de données, en particulier dans au moins un câble optique actif (AOC).

—202:VB

G

D

201

S

VGS

VF

200

203

Fig. 1 [prior art = Stand der Technik]

202

D

G

201

S

204

VGS

VB

VF

200

203

203

203

Fig. 2 [prior art = Stand der Technik]

207:VB2

202:VB1

206

205

204

VB1

D

G

S

201

200

203

203

203

## Fig. 3 [prior art = Stand der Technik]

100

N : 1

102

D

G

S1

D

G

S1

S

104

S

103

106

IL

+ −

105

G

D

107

S

101

I1

## Fig. 4

Fig. 5

Fig. 6

## Fig. 7

## Fig. 8

Fig. 9

Fig. 10

Fig. 11

Fig. 12

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008032556 B3

**In der Beschreibung aufgeführte Nicht-Patentliteratur**

- **U. TIETZE ; CH. SCHENK.** Halbleiter-Schaltungstechnik. Springer-Verlag, 1986, 64, , 69